Europäisches Patentamt

European Patent Office

Office européen des brevets

(19)

(11) **EP 0 732 036 B1**

(12) **EUROPÄISCHE PATENTSCHRIFT**

(45) Veröffentlichungstag und Bekanntmachung des Hinweises auf die Patenterteilung:
**21.05.1997 Patentblatt 1997/21**

(21) Anmeldenummer: **94924834.8**

(22) Anmeldetag: **02.08.1994**

(51) Int Cl.[6]: **H04R 25/00**

(86) Internationale Anmeldenummer:
**PCT/EP94/02560**

(87) Internationale Veröffentlichungsnummer:
**WO 95/15668 (08.06.1995 Gazette 1995/24)**

(54) **SCHALTUNGSANORDNUNG FÜR DIE AUTOMATISCHE REGELUNG VON HÖRHILFSGERÄTEN**

AUTOMATIC REGULATION CIRCUITRY FOR HEARING AIDS

CIRCUITERIE DE REGULATION AUTOMATIQUE D'APPAREILS DE CORRECTION AUDITIVE

(84) Benannte Vertragsstaaten:
**AT CH DE DK GB IT LI NL SE**

(30) Priorität: **01.12.1993 DE 4340817**

(43) Veröffentlichungstag der Anmeldung:
**18.09.1996 Patentblatt 1996/38**

(73) Patentinhaber: **TOPHOLM & WESTERMANN APS**
**DK-3500 Vaerloese (DK)**

(72) Erfinder: **LUDVIGSEN, Carl**
**DK-2500 Valby (DK)**

(74) Vertreter: **Böhmer, Hans Erich, Dipl.-Ing.**
**Keplerstrasse 23**
**71134 Aidlingen (DE)**

(56) Entgegenhaltungen:
**US-A- 4 204 260     US-A- 4 718 099**
**US-A- 4 790 019     US-A- 4 852 175**
**US-A- 4 868 880     US-A- 4 887 299**

## Beschreibung

Die Erfindung betrifft eine Schaltungsanordnung für die automatische Regelung der Verstärkung und/oder des Frequenzganges der Übertragungscharakteristik einer steuerbaren und regelbaren Signalverarbeitungsschaltung eines Hörhilfsgerätes.

Schwerhörige oder Hörbehinderte besitzen typischerweise eine erhöhte Hörschwelle, während der Einfluß auf die obere Schwelle, die sogenannte Schmerzschwelle wesentlich weniger ausgeprägt ist. Daher ist der Dynamikbereich des Hörgeschädigten im Vergleich mit einem normalen Hörempfinden oft deutlich reduziert. Wenn man versucht, diese Behinderung durch ein Hörhilfsgerät zu erleichtern, ergibt sich sofort eine gewisse Schwierigkeit. Wegen des beschränkten Dynamikbereiches in der Hörempfindung eines Hörbehinderten ergeben sich bei einer linearen Verstärkung unausweichlich in einigenfällen, d.h. bei bestimmten Kombinationen von Sprache und Hintergrundgeräusch verstärkte Signale, die im Konflikt mit dem begrenzten Dynamikbereich des das Hörhilfsgerät Benutzenden stehen. Andererseits haben klinische Versuche bei der Verwendung von Hörhilfsgeräten in einer lärmenden und in einer ruhigen Umgebung ergeben, daß eine lineare Verstärkung mit einer gut angepaßten frequenzabhängigen Verstärkung jedem System mit automatischer Verstärkungsregelung bei Einkanal- oder Mehrkanalgeräten in Bezug auf die Sprachverständlichkeit eindeutig überlegen ist.

Es sind bereits verschiedene Geräte bekannt geworden, mit denen das Ausgangsignal eines Hörhilfsgerätes an die verringerte Hörfähigkei eines Hörgeschädigten angepaßt werden kann. Dies trifft sowohl für Einkanal- als auch für Mehrkanal-Hörhilfsgeräte mit automatischer Regelung zu.

In einem Hörhilfsgerät mit einer Einkanal-Verstärkungsregelung ist der zu regelnde Parameter des Hörhilfsgerätes die Verstärkung. Die temporale Charakteristik dieser Regelung ist für die Qualität des zu verarbeitenden Signals von größter Bedeutung. Normalerweise wird der zeitliche Verlauf und das temporale Verhalten einer Schaltung für die automatische Verstärkungsregelung durch die Ansprechzeit und die Abfallzeit bestimmt. Typischerweise werden Ansprechzeiten von einigen wenigen ms und Abfallzeiten von einigen hundert ms für Hörhilfsgeräte als optimal angesehen. Jedoch ist die Arbeitsweise, selbst bei diesen Ansprech- und Abfallzeiten, einer üblichen automatischen Verstärkungsregelung klar hörbar und wirkt sich möglicherweise nachteilig auf die Sprachverständlichkeit und den Hörkomfort aus. Um dies zu vermeiden, sind bereits eine Anzahl verschiedener und etwas komplizierter Schaltungen für die automatische Verstärkungsregelung beschrieben worden. Ein solches System mit zwei unterschiedlichen Abfallzeiten ist in der US-A 4.718.099 beschrieben. Ein weiteres solches System benutzt zwei Eingangsschaltungen für die automatische Verstärkungsregelung, nämlich eine rasch arbeitende und eine langsam arbeitende. Beide dieser Systeme sind weniger empfindlich für laute impulsartige Störungen im Vergleich mit der üblichen automatischen Verstärkungsregelung und beide können als parametrische Regelsysteme bezeichnet werden.

Die Mehrkanaltechnik bietet die Möglichkeit, die Verstärkung in einer Anzahl von Kanälen unabhängig voneinander zu regeln und dadurch das Ausgangsspektrum in größeren Einzalheiten zu steuern. Wenn man daher eine solche automatische Regelung in jedem Kanal vorsieht, dann würde das relativ stationäre Verhalten der automatischen Regelung sich auf den gesamten Frequenzgang des Hörhilfsgerätes auswirken, da dieser durch die Verstärkung in den verschiedenen Kanälen bestimmt wird.

In der US-A 4.852.175 ist ein weiteres Verfahren beschrieben, das die Amplitudenverteilung in einer größeren Anzahl von Kanälen bzw. Frequenzbeändern dazu benutzt, den Frequenzgang eines Mehrkanal-Hörhilfsgerätes einzustellen. Für diesen Zweck wird für jeden Kanal das vollständige Histogramm berechnet und gespeichert und damit die Verstärkung in jedem Kanal so geregelt, daß die jeweils in einen höheren Kanal hineinwirkende Maskierung die Information in den höheren Kanälen nicht beeinträchtigt .

Wenn man aber an Stelle einer parametirschen Regelung eine nicht-parametrische Regelung verwendet, dann kann man eine andere zeitliche Charakteristik erzielen, die offenbar für die Art der Regelung wesentlich besser geeignet erscheint und daher auch qualitativ vorzuziehen ist.

Diese Regelung scheint sogar noch weniger empfindlich für starke impulsförmige Signale und andere relativ schnell erfolgende Änderungen in der Signalamplitude zu sein als die paramtrischen Verfahren.

Die Erfindung gibt nunmehr eine Schaltungsanordnung an, mit der eine solche beträchtliche Verbesserung in der automatischen Regelung von Hörhilfsgeräten erreicht werden kann. Diese neue Schaltungsanordnung ist im Prinzip dem Patentanspruch 1 zu entnehmen.

Weitere Einzelheiten und vorteilhafte Weiterbildungen der Erfindung sind den weiteren Patentansprüchen zu entnehman.

Die Erfindung wird nunmehr anhand von Ausführungsbeispielen in Verbindung mit den beigefügten Figuren im einzelnen beschrieben.

In den Figuren zeigt:

Fig. 1 schematisch ein Mehrkanal-Hörhilfsgerät gemäß der Erfindung;

Fig. 2 rein schematisch eine erste Ausführungsform einer Regelschaltung gemäß der Erfindung für einen Kanal eines Hörhilfsgerätes;

Fig. 3 rein schematisch eine weitere Ausführungsform der in Fig. 2 gezeigten Regelschaltung;

Fig. 4 eine mehr ins Einzelne gehende schematische Darstellung der Schaltung gemäß Fig. 3;

Fig. 5 schematisch die gleiche Schaltung wie Fig. 2 mit digitaler Regelschaltung;

Fig. 6 schematisch die gleiche Schaltung wie Fig. 5, jedoch in vollständig digitaler Ausführungsform;

Fig. 7 ein Diagramm zur Erläuterung der Arbeitsweise der Regelschaltung für einen Perzentile-Wert von 80%;

Fig. 8 ein Histogramm der Energieverteilung eines Sprachsignals;

Fig. 9 ein Histogramm der Energieverteilung eines Störsignals und

Fig. 10 ein Histogramm der Energieverteilung eines aus Sprachsignal und Störsignal zusammenyesetzten Signals.

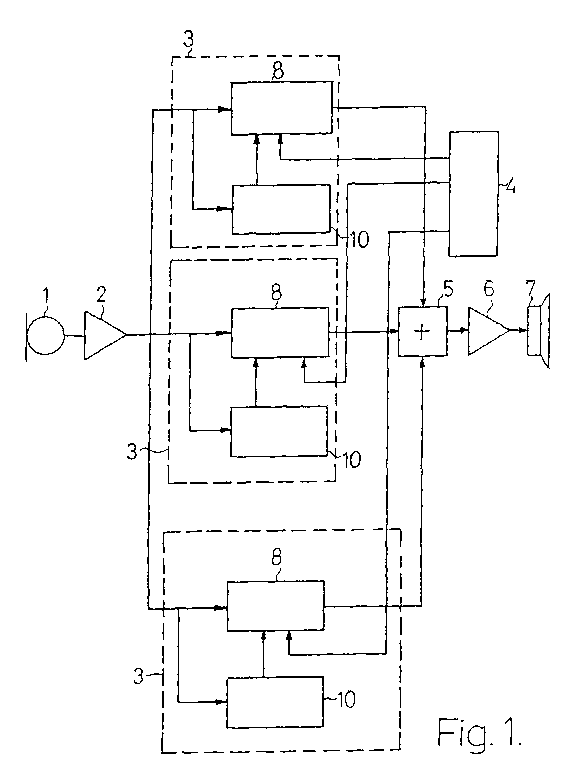

Fig. 1 zeigt ein Hörhilfsgerät in Mehrkanai-Ausführrung gemäß der Erfindung. Selbstverständlich ist auch eine Einkanalversion möglich.

Dieses Hörhilfsgerät besteht zunächst in üblicher Weise aus mindestens einem Mikrofon 1 mit Vorverstärker 2, mindestens einem, im dargestellten Ausführungsbeispiel drei Kanälen mit je einer elektronischen regelbaren bzw. steuerbaren Signalverarbeitungsschaltung 3 mit einem besonderen Register 4. Bei diesem Register kann es sich entweder um ein Speicherregister für die Speicherung von Steuerparametern für den durch das Audiogramm bestimmten Hörverlust des Trägers in normaler Alltagsumgebung handeln oder um ein Empfangsteil mit Demodulator und Speicher/Register für die Aufnahme von Programmdaten/Informationen bzw. Steuerparametern für die Grundeinstellung des Hörgerätes und/oder für die an die Hörbehinderung des Trägers und an unterschiedliche Umgebungssituationen angepaßte Einstellung der Übertragungscharakteristik des Hörgerätes.

Die Aufteilung des Eingangssignals auf die einzelnen Kanäle erfolgt z.B. über eine Anzahl von Bandpaßfiltern, die der Einfachheit halber nicht gezeigt sind. Ferner ist eine Summenschaltung 5, ein Ausgangsverstärker 6 und ein Ausgangswandler 7 vorgesehen.

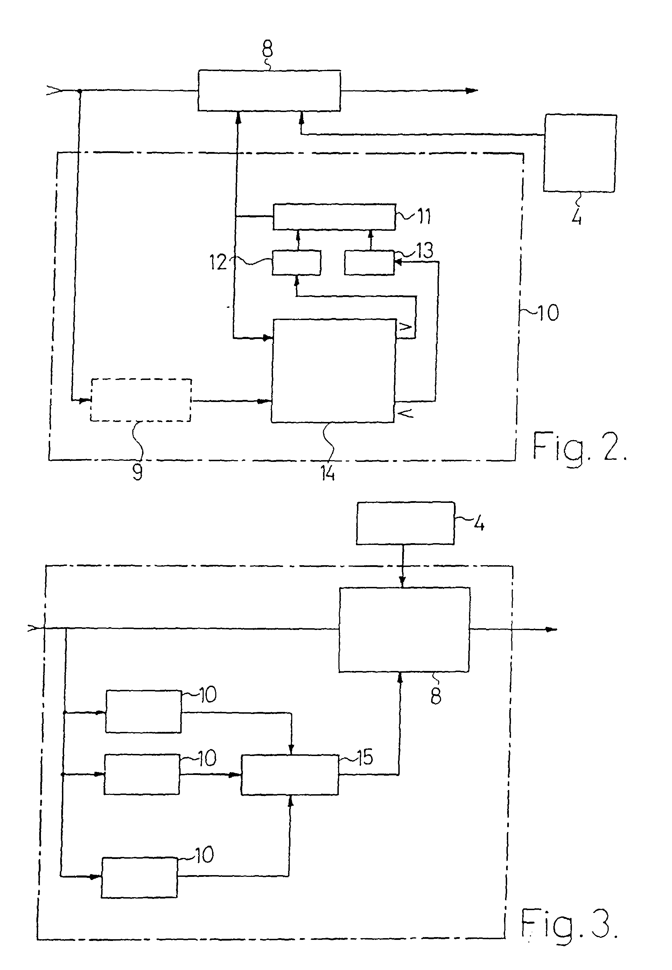

Die elektronische Signalverarbeitungsschaltung 3 enthält mindestens einen elektronischen Signalprozessor 8, ggf. wie noch im Zusammenhang mit Fig. 2 erläutert wird, eine Detektorstufe 9 und mindestens einen Perzentile-Generator 10. Derartige Perzentile-Generatoren sind im Prinzip aus der US-A 4.204.260 bekannt.

Fig. 2 zeigt den Aufbau einer solchen Schaltung. Der Perzentile-Generator 10 besteht in der analogen Ausführungsform, die gleichwertig neben einer noch zu beschreibenden digitalen Ausführungsform betrachtet werden soll, aus einem Integrator 11, beispielsweise einem kapazitiven Speicher und zwei Steuerstufen 12 und 13 sowie aus einer analogen Vergleichsschaltung 14. Die Detektorstufe 9 könnte an sich entfallen, wird aber vorzugsweise verwendet werden.

Ein vom Eingang der Schaltung kommendes Eingangssignal wird in der Detektorstufe 9, z.B. einer Gleichrichterschaltung, kontinuierlich zur Ermittlung der Einhüllenden des Eingangssignals gleichgerichtet. Ebenso ist es möglich, an dieser Stelle statt dessen eine logarithmische Transformation vorzunehmen. Das dabei ermittelte Signal gelangt auf einen Eingang der Vergleichsstufe 14. An deren anderen Eingang liegt die im Integrator 11 gespeicherte Spannung. Ist die vom Eingangssignal abgeleitete Spannungsamplitude größer als die im Integrator gespeicherte Spannung, dann wird ein negativer Steuerimpuls an die Steuerstufe 13 abgegeben, durch den die im Integrator 11 gespeicherte Spannung um einen vorbestimmten Spannungswert verringert wird. Ist aber die Eingangsspannungsamplitude kleiner als die im Integrator 11 gespeicherte Spannung, dann wird ein positiver Steuerimpuls an die Steuerstufe 12 abgegeben, die das Potential im Integrator 11 um einen ebenfalls vorgegebenen Betrag erhöht. DieSteuerstufen 12 und 13 können beispielsweise Potentiometer oder steuerbare Widerstände sein. Das im Integrator 11 liegende Spannungspotential stellt dann, in stark vereinfachter Form, das Regelsignal für den elektronischen Signalprozessor 8 dar. Es muß in diesem Zusammenhang darauf hingewiesen werden, daß die Betrage bzw. die Koeffizienten, um die jeweils bei jedem Vergleich das Spannungspotential des Integrators 11 durch die Steuerstufen 12 oder 13 verändert wird, vorzugsweise nicht gleich sind. Dies wird noch näher erläutert. Erwähnt sei jedenfalls, daß diese Schrittwerte entweder fest eingestellt sind oder einstellbar und sogar programmierbar sein können.

In Fig. 3 ist schematisch ein Kanal eines Einkanal- oder Mehrkanal-Hörhilfsgerätes gezeigt, bei dem ein elektronischer Signalprozessor 8 sowie drei Perzentile-Generatoren 10 vorgesehen sind, deren Ausgangssignal für z.B. Perzentile-Werte von 10%, 50% und 90% in einer Kombinations- und Steuerlogik 15 zusammengefaßt und mittels vorgegebener, ggf. programmierbarer mathematischer Operation zu einem Steuersignal oder zu mehreren Steuer-. signalen zusammengefaßt werden. Selbstverständlich kann für den letzteren Fall die Kombinations- und Steuerlogik 15 so aufgebaut werden, daß für verschiedene Stufen des elektronischen Signalprozessors 8 jeweils eigene Steuer- und Regelsignale über entsprechende Verbindungen zugeführt werden. Auch hier gilt alles, was im Zusammenhang mitFig. 2 erläutert wurde.

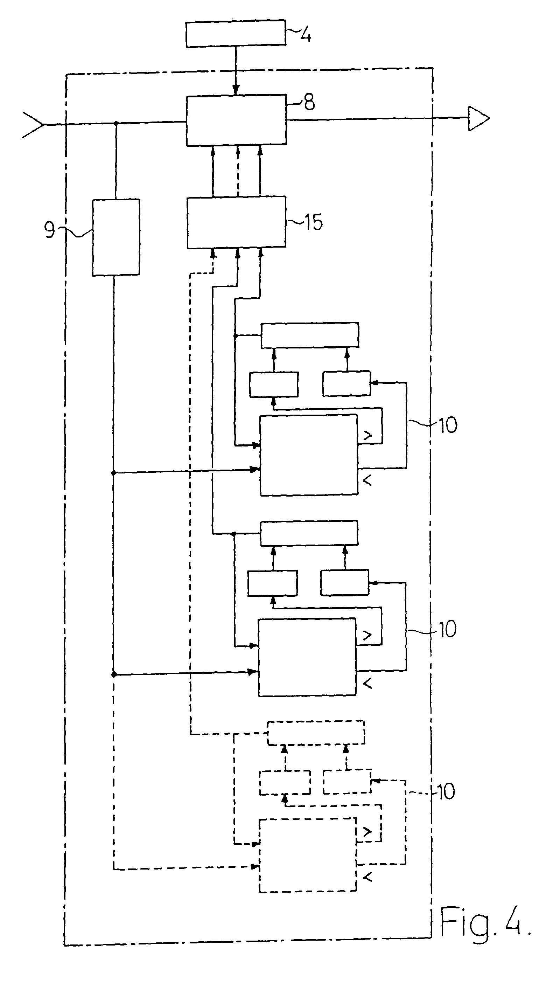

Fig. 4 zeigt im Prinzip einen Kanal des Hörhilfsgerätes gemäß Fig. 3 mit etwas mehr Einzelheiten, die jedoch einer besonderen Erläuterung nicht bedürrfen. Gleiche Teile sind klar erkennbar und im Zusammenhang mit den Figuren 2 und 3 identifizierbar. Die Frequenzanalyse kann dabei in üblicher Weise durch eine Anzahl in ihren Durchlassbereichen im wesentlichen aneinanderschließende Filter erfolgen. Andererseits kann diese Frequenzanalyse auch mittels Fouriertransformation durchgeführt werden.

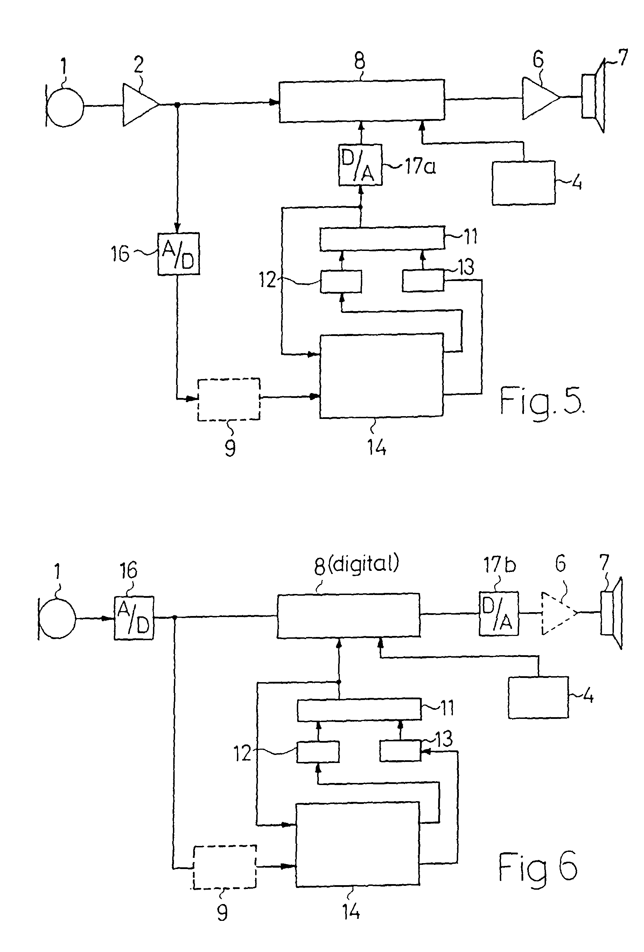

Fig. 5 zeigt wiederum schematisch einen Kanal eines Hörhilfsgerätes, das natürlichauch mehrere Kanäle aufweisen kann, bei das dem Perzentile-Generator 10 zugeführte Eingangssignal in einem Analog/Digitalwandler digitlisiert und das digitale Ausgangssignal des Integrators 11 über einen Digital/Anal ogwandler dem analog arbeitenden elektronischen Signalprozessor 8 zugeleitet wird.

Der Integrator 11 ist in diesem Fall ein reversibler Binärzähler, die Steuerstufen 12 und 13 sind digitale Zählsteuerstufen und die Vergleichsschaltung 14 arbeitet ebenfalls digital, jedoch mit ihrer eigenen Abtastrate, die über einen eigenen Taktgenerator gesteuert wird. Es besteht kein Zusammenhang zwischen der Taktfrequenz der Analog/Digitalwandler und der Digital/Analogwandler und der Taktfrequenz der Vergleichsschaltung 14. Bei einer Zusammenfassung aller Stufen in hochintegrierten Schaltungen könnte man allerdings daran denken, die wesentlich niedrigere Taktfrequenz der Vergleichsschaltung 14 von einem für die Wandler 16 und 17 vorhandenen Taktgenerator abzuleiten.

Auch hier kann eine Detektorstufe 9 vorgesehen sein, die in diesem Fall eine digitale, den Amplitudenwerten des Eingangssignals entsprechende Signalfolge abgibt. Die Zählsteuerstufen 12 und 13 können beispielsweise Register sein, in denen binäre Zählschritte gesp eichert sind, bzw. eingespeichert oder programmiert werden können. Ist bei einem Vergleich der Zählwert des Eingangssignals kleiner als der Zählerstand des reversiblen Zählers 11, so wird dieser um den vorgegebenen Zählwertschritt erhöht. Umgekehrt, wenn bei einem Vergleich der Zählwert des Eingangssignals größer ist als der im Zähler 11 gespeicherte Wert, dann wird der Zählerstand des Zählers 11 um den in der Zählsteuerstufe 13 gespeicherten Zählschrittwert verringert. Auch diese Zählschrittwerte sind vorzugsweise verschieden. Dies wird noch näher erläutert.

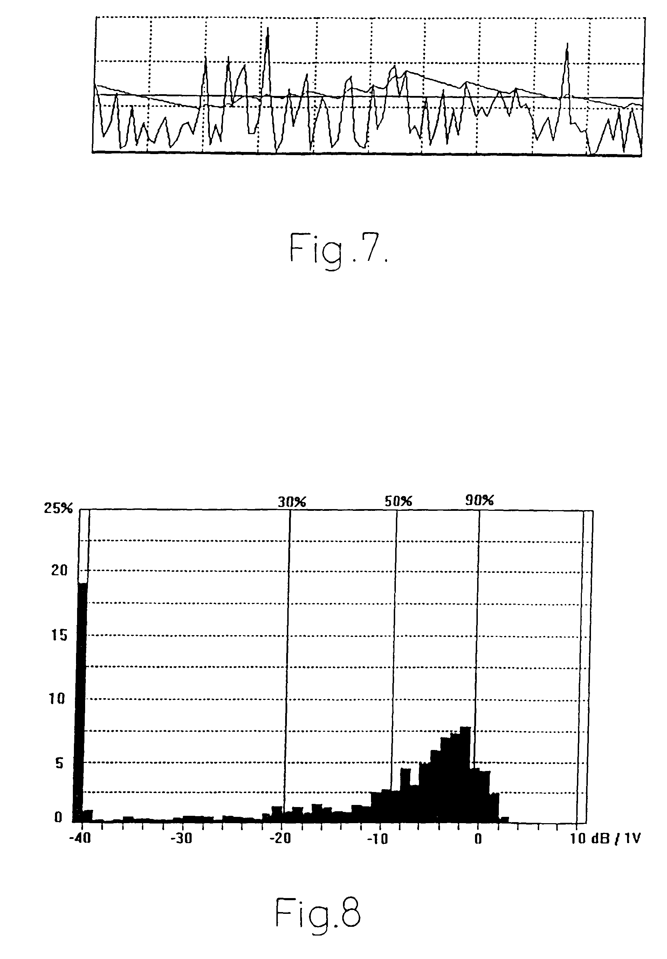

Fig. 6 zeigt die vollständig in digitaler Technik ausgeführte Schaltung. Gleiche Teile sind mit gleichen Bezugszeichen versehen und bedürfen keiner besonderen Erläuterung. Der Signalprozessor 8 ist eine voll digitale Schaltung, bestehend beispielsweise aus digitalen steuerbaren Filtern, digitalen steuerbaren Dämpfungsgliedern und digitalen Verstärkerstufen evtl. sogar digitalen Kompressionsschaltungen. Es ist einleuchtend, daß man in diesem Fall möglichst viele elektronische Schaltkreise zu hochintegrierten Schaltungen zusammenfassen kann.

Die Arbeitsweise dieser sehr komplexen Schaltung soll nunmehr anhand der Figuren 7 bis 10 erläutert werden.

Die Ermittlung von Perzentile-Werten kann auf verschiedene Weise, analog oder digital, vorgenommen werden. Die Zeitfunktionen der zu ermittelnden Perzentile-Werte hängen von der Wahl der Zeitintervalle zwischen den einzelnen Vergleichen und den jeweiligen Werten ab, mit denen der im Integrator 11 bzw. im reversiblen Zähler gespeicherte Wert jeweils erhöht oder verringert wird. Dabei werden folgende Ausdrücke und Symbole verwendet:

Perzentile-Pegel, z.B. 75 dB SPL (Signal-Schalldruckpegel), d.h. der Pegel, unterhalb dessen p Prozent alle diskreten Signalwerte liegen;

u = die Anzahl der Aufwärts-Zählschritte/Sekunden

d = die Anzahl der Abwärts-Zählschritte/Sekunde
Daraus erhält man:

$$p = 100\ u/(u + d).$$

Die Werte von u und d können mit einer Konstanten multipliziert werden, ohne daß sich dabei der Wert von p ändert. Diese Berechnung kann auch als ein sich auf Addition beziehendes Verfahren angesehen werden. D. h. ein bestimmter Wert wird zu einem beispielsweise im Integrator 11 gespeicherten Wert addiert, wenn der bisher vorliegende Wert kleiner ist als der Augenblickswert des Signals. Dagegen wird ein anderer Wert von dem Wert im Integrator 11 subtrahiert, wenn dieser Wert größer ist als der Augenblickswert des Signals.

Ebenso kann das Verfahren mittels Multiplikation durchgeführt werden.

Der im Integrator 11 liegende Wert wird dann mit einem Faktor a < 1 multipliziert, wenn der gespeicherte Wert größer ist als der Augenblickswert des Eingangssignals bzw. dessen Einhüllenden oder eines logarithmisch transformierten Signals bzw. mit b > 1 multipliziert, wenn der gespeicherte Wert kleiner ist als der Augenblickswert des Signals.

Die Beziehung zwischen p, a und b lautet in diesem Fall

$$p = 100 \log (b) / \log (b) \text{ minus } \log (a).$$

a und b können dabei zu einer bestimmten Potenz erhoben werden, ohne daß sich dabei der Wert von p ändert. Dies wird jedoch einen Einfluß auf die "Zeitkonstanten" der jeweiligen Änderungen haben.

Dazu soll dieses an einem Beispiel für das additive Verfahren erläutert werden. Wenn z.B. der reversible Zähler 11 ein Register mit 15 Bit mit möglichen Werten von 0 bis 32.768 ist und der Perzentile-Generator 10 die 80% Perzentile annähern soll, dann erhält man mit p = Perzentile, u = Aufwärtszählschritte in der Zählsteuerstufe 12 und d = Abwärtzählschritte in der Zählsteuer-stufe 13 die Formeln

$$p = 100 \ u \ / \ (u+d)$$

oder

$$u = d \times p \ / \ (100 - p)$$

oder

$$u = d \times 4.$$

Von hier aus können die Werte für u und d frei gewählt werden, jedoch wird ihr absoluter Wert direkten Einfluß auf die Ansprechzeit des Systems ausüben. Das gleiche gilt für die Abfallzeit.
Wählt man beispielsweise d = 10.000 und u = 40.000, dann bedeutet dies, daß bei einer Änderung des Eingangssignals von Stille auf einen im wesentlichen konstanten Schall das System sich in weniger als einer Sekunde auf die neue Situation eingestellt haben wird. (Ansprechzeit = 32.768 / 40.000 sec. = 0,8192 sec.)
Der Übergang von dieser Schallsituation wird dagegen mehr als drei Sekunden benötigen (Abfallzeit = 32.768 / 10.000 sec. = 3, 2768 sec. ) bis das System sich voll auf die alte Situation wieder eingestellt hat.
Wählt man dagegen d = 2.000 und u = 8.000, dann erhält man eine Ansprechzeit von 4,096 sec und dementsprechend eine Abfallzeit von 16,384 sec.
Man sieht also, daß für das gewünschte Perzentile die gewünschten Ansprech- und Abfallzeiten leicht einstellbar und somit auch programmierbar sind.
Wie dies im einzelnen bei einem einfachen Beispiel aussieht, zwigt Fig. 7. Dort ist als Beispiel eine Einhüllendenfunktion und der zeitliche Verlauf der Berechnung des 80%-Perzentiles dargestellt. Die berechnete Perzentile ist als horizontale Linie dargestellt.
Die Einhüllendenfunktion der Fig. 7 wird aus dem Eingangssignal durch einfache Gleichrichtung ermittelt. Jedoch sind auch andere mehr oder weniger komplexe Verfahren möglich. Wie bereits gesagt, ist der Pegel,unterhalb dessen 80% der einzelnen Signalwerte liegen, durch eine horizontale Linie dargestellt. Die Berechnung erfolgt in der Weise, daß der Perzentile-Generator auf einen ersten, einen Anfangswert eingestellt wird. In diesem Fall ist es die Amplitude des ersten Signalwertes. Der Augenblickswert des nächsten Signalwertes wird mit dem eben gespeicherten Wert verglichen. Ist der gespeicherte bzw. der dann ermittelte Wert kleiner als der nächste Signalwert, dann wird der gespeicherte Wert um einen vorbestimmten Betrag erhöht. Dies ist deutlich erkennbar.
Ist jedoch der nächste Signalwert größer als der zuvor gespeicherte Wert, dann wird der gespeicherte Wert um einen vorgegebenen Betrag verringert. Die 80%-Perzentile wurde nach der oben mitgeteilten Formel multiplikativ berechnet mit a = 0,9765 und b = 1,1.
Anhand der Figuren 8, 9 und 10 soll jetzt gezeigt werden, welche Auswirkungen die verschiedenen Umgebungssituationen auf die Energieverteilung haben, wobei jeweils die Perzentile 30%, 50% und 90% dargestellt sind.
Der quadratische Mittelwert von 1.250 aufeinanderfolgenden 20 ms langen Intervallen eines fortlaufenden Schallereignisses, hier z.B. Sprache, werden berechnet. Somit hat das hier analysierte Sprachsignal eine Gesamtdauer von 1.250 x 0, 02 sec = 25 sec. Die Kurzzeitpegel der quadratischen Mittelwerte werden entsprechend ihren Werten in Klassen mit einer Breite von 1 dB klassifiziert. Die relative Anzahl in jeder Klasse wird durch ein Histogramm dargestellt. So ist beispielsweise aus Fig. 8 ersichtlich, daß 5 % der Intervalle einen quadratischen Mittelwert zwischen -5 und -6 dB, relativ zu 1 Volt (dB / 1 V) aufweisen. Insbesondere ist bemerkenswert, daß die Pegel von nahezu 19% aller Intervalle unterhalb von -40 dB / 1 V liegen.

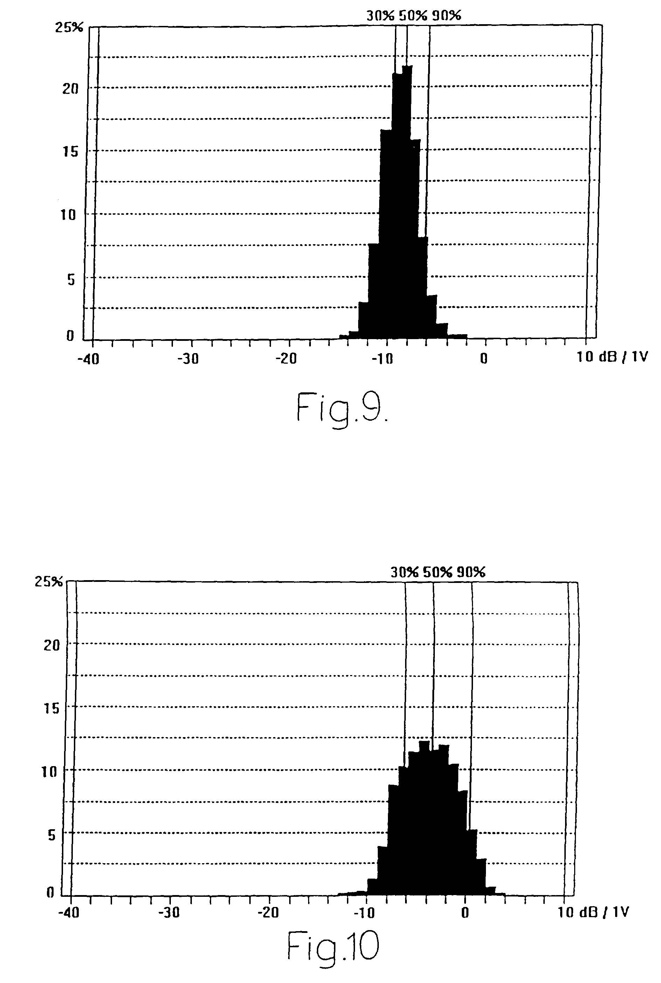

Fig. 9 zeigt ein Histogramm der Verteilung der Kurzzeitpegel eines Störsignals (das in einer Party verursachte Geräusch). Dabei sind die Pegel entsprechend den Perzentilen 30%, 50% und 90% dargestellt.
Die quadratischen Mittelwerte der Pegel von 1.250 aufeinanderfolgenden 20 ms langen Intervallen eines sogenannten Partygeräusches werden berechnet. Die gesamte Dauer des Störsignals beträgt 25 sec. Aus Fig. 9 erkennt man, daß ungefähr 22% der Intervalle einen quadratischen Mittelwert zwischen -8 und -9 dB/ 1 V aufweisen. Keine Signalpegel liegen unterhalb von -15 dB / 1 V.
Fig. 10 zeigt schließlich in einem Histogramm die Kurzzeitverteilung eines aus Sprache und Störgeräusch zusammengesetzten Signals. Die Pegel entsprechen wieder den Perzentilen 30%, 50% und 90%.
Das Sprachsignal der Fig. 8 wird mit dem Sprachsignal der Fig. 9 überlagert. Die quadratischen Mittelwerte der Pegel von 1.250 aufeinanderfolgenden 20 ms langen Intervallen des Mischsignals wurden berechnet. Man erkennt aus Fig. 10, daß ungefähr 5% der Intervalle einen quadratischen Mittelwert zwischen 1 und 0 dB / 1 V aufweisen. Keine Intervalle hatten Pegel unterhalb von -13 dB /1 V.
Man sieht also, daß normale fortlaufende Sprache ohne große Lautstärkeschwankungen sich um einen vorgegebenen Perzentile-Wert konzentrieren wird. Dabei wird sich das Signal um den vorgegebenen Perzentile-Wert einpendeln und kein Regelsignal erzeugen, das die Verstärkung und/oder den Frequenzgang des elektronischen Signalprozessors ändert. Kommt jedoch ein Störsignal gemäß Fig. 9 hinzu, dann ändert sich die Amplitudenverteilung drastisch, und es wird ein Regelvorgang eingeleitet, der je nach Anzahl der Kanäle mit ihren Kanal-Signal prozessoren und der Anzahl der steuerbaren oder regelbaren Stufen der Signalprozessoren eine erhebliche Änderung der Übertragungscharakteristik bewirken wird. Mit anderen Worten, die zur Regelung erforderlichen Regelgrößen werden aus dem Eingangssignal mit Hilfe der Perzentile-Generatoren abgeleitet.

Zum besseren Verständnis sei nunmehr noch die Funktion der Kombinations- und Steuerlogik 15 etwas eingehender erläutert.

Es ist eine typische Eigenschaft von kontinuierlichen Schallereignissen, wie von Umgebungs- Störgeräuschen und von manchen Arten von Musik, daß die Verteilung der Kurzzeitpegel der quadratischen Mittelwerte, gemessen auf einer dB-Skala, nahezu symmetrisch ist, d.h. daß die Perzentile 50% angenähert dem arithmetischen Mittelwert der Perzentile 10% und 90% entspricht, wie dies z.B. Fig. 9 zeigt.

Andererseits ist es ebenso charakterisstisch für impulsförmige Schallereignisse, wie klopfende Geräusche, Hämmern oder Sprache, daß deren Verteilung der Kurzzeitpegel der quadratischen Mittelwerte unsymmetrisch ist, d.h. daß die Perzentile 50% weit entfernt vom arithmetischen Mittelwert der Pegel der Perzentile 10% und 90% liegt. Dies zeigt z.B. Fig. 8.

Dies ist auf die Pausen zwischen den Impulsen oder den Sprachsegmenten zurückzuführen .

Daher kann man in einem tatsächlich gebauten Hörhilfsgerät die Werte der Perzentile 10 %, 50 % und 90% in Kombination benützen, um zu entscheiden, ob die Schallumgebung einen kontinuierlichen oder einen impulsförmigen Charakter aufweist. Dies ist von ganz entscheidender Bedeutung, da Stör- oder Hintergrundgeräusche einen Einfluß auf die Sprachverständlichkeit dadurch ausüben, daß die Sprache maskiert, d.h. überdeckt wird. Die Maskierwirkung impulsförmiger Störungen unterscheidet sich jedoch grundsätzlich von der Maskierungswirkung kontinuierlicher Geräusche und erfordem somit eine unterschieliche Art der Regelung.

Die Wirkung der Kombinations- und Steuerlogik 15 kann also darin bestehen, ein Regelsignal zu erzeugen, das darin besteht, daß es entweder proportional oder in anderer Beziehung zu dem metrischen Wert der Ausgangssignale der drei Perzentile-Generatoren steht. Dieser Wert wird nach der Formel (Pegel 90 % x Pegel 10 % - 2 x Pegel 50 %). berechnet.

Für eine symmetrische Verteilung der Kurzzeitpegel der quadratischen Mittelwerte wird dann dieser metrische Wert angenähert Null sein, während er entweder positiv oder negativ sein wird, je nach dem die Verteilung, wie in den Histogrammen nach links oder nach rechts vom Mittelwert verschoben ist. D.h. die Perzentile-Generatoren 10 könnten für einen ersten Perzentile-Wert von 10 % für den oberen Perzentile-Generator, einen zweiten Perzentile-Wert von 90 % für den mittleren Perzentile-Generator und einen dritten Perzentile-Wert von 50 % für den unteren Perzentile-Generator gewählt werden. Die dabei ermittelten Ausgangswerte könnten dann in der Kombinations-und Steuerlogik gemäß der oben angegebenen Beziehung kombiniert werden, und je nach Art und Größe des kombinierten Ausgangssignals der drei Perzentile-Generatoren ein Regelsignal liefern, das beispielsweise die Verstärkung herunterregelt, sie nicht verändert oder hochregelt. Dies gilt für einen Kanal oder für mehrere Kanäle.

Abschließend sei noch bemerkt, daß sowohl die Steuerung der Steuerstufen 12 und 13 als auch die Steuerung der Kombinations- und Steuerlogik 15 über eine gemeinsame zentrale Steuereinheit, z.B. einen Mikroprozessor erfolgen kann, der seinerseits durchaus auch von einem externen Steuergerät aktivierbar sein kann.

Da sowohl die Zählschrittwerte als auch die den Perzentile-Generatoren vorgegebenen Perzentile-Werte im Prinzip frei wählbar sind, ggf. auch über eine Fernsteuerung aktivierbar oder programmierbar sein können, sind viele Variationsmöglichkeiten für die vom Eingangssignal abhängige automatische Regelung von Hörhilfsgeräten erzielbar.

**Patentansprüche**

1. Schaltungsanordnung für ein vorzugsweise programmierbares Hörhilfsgerät mit mindestens einem Mikrofon, mindestens einer elektronischen Signalverarbeitungsschaltung (3), mit mindestens einem Kanal und einem Ausgangswandler (7), bei welchem die elektronische Signalverarbeitungsschaltung (3) eine Regelschaltung für die fortlaufende Ermittlung bzw. Berechnung eines Perzentilwertes oder mehrerer Perzentil-werte des Eingangssignals aus einer fortlaufenden Analyse und Auswertung der Frequenz- und/oder Amplitudenverteilung des Eingangssignals enthält, wobei diese Perzentile-Werte unmittelbar oder mittelbar als Steuersignale für die Regelung der Verstärkung und/oder des Frequenzganges der elektronischen Signalverarbeitungsschaltung(en) dienen.

2. Schaltungsanordnung nach Anspruch 1 mit mindestens einem eingangsseitig angeschlossenen Perzentile-Generator (10), der aus einem Integrator (11) und einer ersten damit verbundenen Steuerstufe (12) für die Aufwärtszählung und einer zweiten damit verbundenen Steuerstufe (13) für die Abwärtszählung und einer Vergleichsstufe (14) mit mindestens zwei Eingängen besteht, wobei der Eingang der Schultung unmittelbar oder mittelbar mit einem Eingang der Vergleichsstufe (14) verbunden ist, während ein zweiter Eingang der Vergleichsstufe mit dem Ausgang des Integrators (11) und direkt oder aber indirekt über eine Kombinations- und Steuerlogik (15) über mindestens eine Steuerleitung mit der Signalverarbeitungsschaltung (3) verbunden ist, während die beiden Ausgänge der Vergleichsstufe (14) mit der Steuerstufe (12) bzw. der Steuerstufe (13) verbunden sind.

3. Schaltungsanordnung für ein Hörhilfsgerät nach Anspruch 1 und 2, bei welchem für die fortlaufende Ermittlung einer Signalfolge aus dem E ingangssignal zwischen dem Eingang der Schaltung und dem Eingang des Perzentile-Generators (10) zur mathematisch-operativen Bearbeitung des Eingangssignals mittels vorgegebener oder vorgebbarer Algorithmen oder Rechenregeln eine Detektorstufe (9) eingeschaltet ist.

4. Schaltungsanordnung für ein Hörhilfsgerät nach Anspruch 1 bis 3, bei welchem zwischen dem Eingang der Schaltung und dem Eingang des Perzentile-Generators als Detektorstufe (9) ein Gleichrichter zur fortlaufenden Ermittlung der Einhüllenden des Eingangssignals eingeschaltet ist.

5. Schaltungsanordnung für ein Hörhilfsgerät nach Anspruch 1 bis 4 mit mindestens zwei Kanälen, bei welchem mindestens in zwei parallelen im wesentlichen aneinanderschließende Frequenzbereiche abdeckenden Kanälen mindestens zwei Perzentile-Generatoren parallel angeordnet sind und Ausgänge der Integratoren (11) dieser Perzentile-Generatoren der jeweiligen Kanäle mit den Eingängen der jeweiligen Kombinations- und Steuerlogik (15) verbunden sind, die ihrerseits über mindestens eine Steuerleitung an der Signalverarbeitungsschaltung (3) des betreffenden Kanals angeschlossen ist.

6. Schaltungsanordnung für ein Hörhilfsgerät nach Anspruch 1 bis 5, bei welchem in der elektronischen Signalverarbeitungsschaltung (3) mittels der Perzentile-Generatoren (10) in jedem Übertragungskanal des Hörhilfsgerätes mindestens zwei Perzentile-Werte berechenbar sind, wobei in jedem Kanal eine vorgegebene oder programmierbare Kombination dieser Perzentile-Werte zur Regelung der Verstärkung dieses Kanals dient.

7. Schaltungsanordnung für ein Hörhilfsgerät nach Anspruch 6, bei welchem die Perzentil-Werte und/oder die Steueralgorithmen durch den Träger des Hörhilfsgerätes veränderbar oder austauschbar sind.

8. Schaltungsanordnung für ein Hörhilfsgerät nach Anspruch 6 oder 7, bei welchem die Veränderung oder der Austausch von Perzentilen und/oder Steueralgorithmen mittels eines Fernsteuergerätes durchführbar sind.

9. Schaltungsanordnung für ein Hörhilfsgerät nach Anspruch 1, bei welchem der mindestens eine Perzentil-Generator (10) über einen am Eingang angeschlossenen Analog/Digitalwandler (16) angeschlossen ist, wobei der Perzentile-Generator (10) als Integrator einen reversiblen binären Zähler mit einer daran angeschlossenen Aufwärts Zählsteuerstufe (12) und einer ebenfalls daran angeschlossenen Abwärts-Zählsteuerstufe (13) sowie eine digitale Vergleichsstufe (14) enthält, während die mindestens eine Ausgangsleitung des Perzentile-Generators als Steuerleitung für die Signalverarbeitungsschaltung (3) über einen Digital/Analogwandler (17) an dieser angeschlossen ist.

10. Schaltungsanordnung für ein Hörhilfsgerät nach Anspruch 9, bei welchem in den beiden Steuerstufen, (12, 13) die Anzahl der bei jedem Vergleich im reversiblen Zähler (11) auszulösenden positiven oder negativen Zählschritte fest eingestellt sind bzw. einstellbar oder programmierbar sind.

11. Schaltungsanordnung für ein Hörhilfsgerät nach Anspruch 10, bei welchem die Anzahl der in beiden Steuerstufen (12, 13) eingestellten bzw. einstellbaren Zählschritte gleich groß ist.

12. Schaltungsanordnung für ein Hörhilfsgerät nach Anspruch 10, bei welchem die Anzahl der in de n beiden Steuerstufen (12, 13) eingestellten bzw. einstellbaren Zählschritte verschieden groß, insbesondere in einer der beiden Steuerstufen wesentlich größer ist als in der anderen.

13. Schaltungsanordnung für ein Hörhilfsgerät nach Anspruch 9, bei welchem zwischen dem Analog/Digitalwandler (16) und dem Eingang des Perzentile-Generators eine Stufe (9) zur Ermittlung einer Signalfolge mittels einer mathematischen Operation oder zur Ermittlung der Einhüllenden eingeschaltet ist.

14. Schaltungsanordnung für ein Hörhilfsgerät nach einem der Ansprüche 1 bis 13, bei welchem das Mikrofon (1) mit Vorverstärker (2) über einen Analog/Digitalwandler (16) an mindestens einer digitalen, regelbaren und steuerbaren Signalversrbeitungsschaltung (3) und an mindestens einer ebenfalls digitalen Regelschaltung mit Perzentile-Generator ( en ) (10) angeschlossen ist, während der Ausgang der gesamten Schaltung über einen Digital/Analogwandler (17) mit dem Ausgangswandler (7) verbunden ist.

15. Schaltungsanordnung nach einem der Ansprüche 1 bis 14 für ein Hörhilfsgerät, bei welchem das Register (4) eine Empfangsschaltung mit Demodulator und einen Speicher für die Aufnahme von Programmdaten/Informationen bzw. Steuerparametern aus einem Fernsteuergerät enthält, die für die Grundeinstellung des Hörgerätes und/oder für an die Hörbehinderung des Trägers und unterschiedliche Umgebungssituationen angepaßte Einstellungen der Übertragungscharakteristik des Hörgerätes bestimmt sind.

**Claims**

1.  Circuit arrangement for a preferably programmable hearing aid with at least one microphone, at least one electronic signal processing circuit (3), with at least one channel and one output transducer (7), in which the electronic signal processing circuit (3) contains a control circuit for continuous determination or calculation of a percentile value or several percentile values of the input signal from a continuous analysis and evaluation of the frequency and/or amplitude distribution of the input signal, whereby said percentile values serve either directly or indirectly as control signals for controlling the gain and/or frequency response of the electronic signal processing circuit(s).

2.  Circuit arrangement in accordance with Claim 1 with at least one percentile estimator (10) connected on the input side, said percentile estimator consisting of an integrator (11) and a first control stage (12) connected to this for up-counting and a second control stage (13) connected to this for down-counting and of a comparator stage (14) with at least two inputs, whereby the input of the circuit is connected directly or indirectly with one input of the comparator stage (14), a second input of the comparator stage being connected with the output of the integrator (11) and directly or indirectly with the signal processing circuit (3) via a combination and control logic (15) via at least one control line, with the two outputs of the comparator stage (14) being connected with the control stage (12) or the control stage (13).

3.  Circuit arrangement for a hearing aid in accordance with Claims 1 and 2, in which, for the purpose of continuous determination of a signal sequence from the input signal, a detector stage (9) is connected between the input of the circuit and the input of the percentile estimator (10) for mathematic processing of the input signal by way of predefined or predefinable algorithms or calculating rules.

4.  Circuit arrangement for a hearing aid in accordance with Claims 1 to 3, in which, for the purpose of continuous determination of the envelope of the input signal, a rectifier is connected between the input of the circuit and the input of the percentile estimator as a detector stage (9).

5.  Circuit arrangement for a hearing aid in accordance with Claims 1 to 4 with at least two channels, in which at least two percentile estimators are connected in parallel in at least two parallel channels covering essentially adjacent frequency bands and in which the outputs of the integrators (11) of these percentile estimators of the respective channels are connected with the inputs of the respective combination and control logic (15), said combination and control logic being connected in turn to the signal processing circuit (3) of the respective channel via at least one control line.

6.  Circuit arrangement for a hearing aid in accordance with Claims 1 to 5, in which at least two percentile values can be calculated in the electronic signal processing circuit (3) by means of the percentile estimators (10) in each transmission channel of the hearing aid, whereby a predefined or programmable combination of these percentile values serves to control the gain of the respective channel in each channel.

7.  Circuit arrangement for a hearing aid in accordance with Claim 6, in which the percentile values and/or control algorithms can be adjusted or exchanged by the wearer of the hearing aid.

8.  Circuit arrangement for a hearing aid in accordance with Claim 6 or 7, in which the adjustment or exchange of percentiles and/or control algorithms can be performed by means of a remote control device.

9.  Circuit arrangement for a hearing aid in accordance with Claim 1, in which at least one percentile estimator (10) is connected via an analog/digital converter (16) connected at the input, whereby the percentile estimator (10) contains as an integrator a reversible binary counter with an up-counting control stage (12) connected to said counter and a down-counting control stage (13) also connected to said counter as well as a digital comparator stage (14), at least one output line of the percentile estimator being connected to the signal processing circuit (3) via a digital/analog converter (17) as a control line for said signal processing circuit.

10. Circuit arrangement for a hearing aid in accordance with Claim 9, in which the number of positive or negative counting steps to be initiated in the reversible counter (11) after every comparison is fixed or adjustable or programmable in the two control stages (12, 13).

11. Circuit arrangement for a hearing aid in accordance with Claim 10, in which the number of the counting steps set or adjustable in the two control stages (12, 13) is the same.

12. Circuit arrangement for a hearing aid in accordance with Claim 10, in which the number of the counting steps set or adjustable in the two control stages (12, 13) differs, and in particular is significantly larger in one of the two control stages than in the other.

13. Circuit arrangement for a hearing aid in accordance with Claim 9, in which a stage (9) for determination of a signal sequence by means of a mathematical operation or for determination of the envelope is connected between the analog/digital converter (15) and the input of the percentile estimator.

14. Circuit arrangement for a hearing aid in accordance with one of Claims 1 to 13, in which the microphone (1) with preamplifier (2) is connected via an analog/ digital converter (16) to at least one digital, closed-loop-controllable and open-loop-controllable signal processing circuit (3) and to at least one also digital control circuit with percentile estimator(s) (10), the output of the whole circuit being connected with the output transducer (7) via a digital/analog converter (17).

15. Circuit arrangement in accordance with one of Claims 1 to 14 for a hearing aid, in which the register (4) contains a receive circuit with demodulator and a memory for storing program data/information or control parameters from a remote control device, said program data/information or control parameters being intended for basic adjustment of the hearing aid and/or for adjustment of the transmission characteristic of the hearing aid corresponding to the hearing impairment of the wearer and different environmental situations.

## Revendications

1. Circuit pour une prothèse auditive de préférence programmable, avec au moins un microphone, au moins un circuit électronique de traitement du signal (3), avec au moins un canal et un transducteur de sortie (7), pour laquelle le circuit électronique de traitement du signal (3) renferme un circuit de régulation pour la détermination ou le calcul continu d'une ou de plusieurs valeurs en pourcentage du signal d'entrée à partir d'une analyse et d'une évaluation continues de la distribution de fréquence et/ ou d'amplitude du signal d'entrée, ces valeurs en pourcentage servant directement ou indirectement de signaux de commande pour la régulation de l'amplification et/ou de la courbe de réponse du (des) circuit(s) électronique(s) de traitement du signal.

2. Circuit selon la revendication 1, avec au moins un générateur de pourcentages (10) raccordé côté entrée, composé d'un intégrateur (11) et d'un premier étage de commande (12), relié à celui-ci, pour le comptage en avant et d'un second étage de commande (13), relié à celui-ci, pour le comptage en arrière, et d'un étage comparateur (14) avec au moins deux entrées, l'entrée du circuit étant reliée directement ou indirectement à une entrée de l'étage comparateur (14), tandis qu'une seconde entrée de l'étage comparateur est reliée à la sortie de l'intégrateur (11), et directement ou indirectement par une logique de combinaison et de commande (15), par au moins une ligne de commande, au circuit de traitement du signal (3), tandis que les deux sorties de l'étage comparateur (14) sont reliées à l'étage de commande (12) ou à l'étage de commande (13).

3. Circuit pour une prothèse auditive selon l'une et l'autre des revendications 1 et 2, pour laquelle un étage détecteur (9) est connecté entre l'entrée du circuit et l'entrée du générateur de pourcentages (10) pour le traitement mathématique-opérationnel du signal d'entrée au moyen d'algorithmes ou de règles de calcul spécifiés ou spécifiables, pour la détermination en continu d'une séquence de signaux à partir du signal d'entrée.

4. Circuit pour une prothèse auditive selon l'une quelconque des revendications 1 à 3, pour laquelle un redresseur est connecté entre l'entrée du circuit et l'entrée du générateur de pourcentages, en tant qu'étage détecteur (9), pour la détermination continue de l'enveloppante du signal d'entrée.

5. Circuit pour une prothèse auditive selon l'une quelconque des revendications 1 à 4, avec au moins deux canaux, pour laquelle au moins deux générateurs de pourcentages sont disposés en parallèle au moins dans deux canaux parallèles, couvrant pour l'essentiel des gammes de fréquences contiguës et pour laquelle les sorties des intégrateurs (11) de ces générateurs de pourcentages des canaux respectifs sont reliées aux entrées de la logique de combinaison et de commande (15) correspondante, qui elle-même est reliée, par au moins une ligne de commande, au circuit de traitement du signal (3) du canal concerné.

6. Circuit pour une prothèse auditive selon l'une quelconque des revendications 1 à 5, pour laquelle au moins deux pourcentages peuvent être calculés dans chaque canal de transmission de la prothèse auditive, dans le circuit électronique de traitement du signal (3) au moyen des générateurs de pourcentages (10), une combinaison donnée ou programmable de ces pourcentages servant, dans chaque canal, à la régulation de l'amplification de ce canal.

7. Circuit pour une prothèse auditive suivant la revendication 6, pour laquelle les pourcentages et/ou les algorithmes de commande peuvent être modifiés ou changés par le porteur de la prothèse auditive.

8. Circuit pour une prothèse auditive selon l'une ou l'autre des revendications 6 ou 7, pour laquelle la modification ou le changement de pourcentages et/ou d'algorithmes de commande peuvent être effectués à l'aide d'une commande à distance.

9. Circuit pour une prothèse auditive selon la revendication 1, pour laquelle au moins un générateur de pourcentages (10) est relié par l'intermédiaire d'un convertisseur analogique/numérique (16) relié à l'entrée, le générateur de pourcentages (10), en tant qu'intégrateur, renfermant un compteur binaire réversible auquel est relié un étage de commande de comptage en avant (12) ainsi qu'un étage de commande de comptage en arrière (13) de même qu'un étage comparateur numérique (14), tandis que la ligne de sortie minimale prévue du générateur de pourcentages est reliée, comme ligne de commande pour le circuit de traitement du signal (3) par un convertisseur numérique/analogique (17) à celui-ci.

10. Circuit pour une prothèse auditive selon la revendication 9, pour laquelle le nombre des incréments de comptage positifs ou négatifs à déclencher dans le compteur réversible (11) à chaque comparaison est réglé de manière fixe ou est réglable ou programmable dans les deux étages de commande (12, 13).

11. Circuit pour une prothèse auditive selon la revendication 10, pour laquelle le nombre des incréments de comptage réglés ou réglables dans les deux étages de commande (12, 13) est identique.

12. Circuit pour une prothèse auditive selon la revendication 10, pour laquelle le nombre des incréments de comptage réglés ou réglables dans les deux étages de commande (12, 13) est différent, et est en particulier considérablement plus élevé dans l'un des deux étages de commande que dans l'autre.

13. Circuit pour une prothèse auditive selon la revendication 9, pour laquelle un étage (9) servant à déterminer une séquence de signaux au moyen d'une opération mathématique ou à déterminer l'enveloppante, est connecté entre le convertisseur analogique/numérique (16) et l'entrée du générateur de pourcentages.

14. Circuit pour une prothèse auditive selon l'une quelconque des revendications 1 à 13, pour laquelle le microphone (1) avec le préamplificateur (2) est relié, par un convertisseur analogique/numérique (16) à au moins un circuit numérique régulable et commandable de traitement du signal (3) et à au moins un circuit de régulation, également numérique, avec générateur(s) de pourcentages (10), tandis que la sortie de l'ensemble du circuit est reliée au transducteur de sortie (7) par un convertisseur numérique/analogique (17).

15. Circuit selon l'une quelconque des revendications 1 à 14, pour une prothèse auditive pour laquelle le registre (4) renferme un circuit récepteur avec un démodulateur et une mémoire pour l'enregistrement de données de programmes/informations ou de paramètres de commande à partir d'une commande à distance, destinés au réglage de base de la prothèse auditive et/ou à des réglages de la caractéristique de transfert de la prothèse auditive adaptés au handicap auditif du porteur et à différentes situations environnantes.

Fig. 1.

Fig. 2.

Fig. 3.

Fig.4.

EP 0 732 036 B1

Fig.5.

Fig 6

14

Fig.7.

Fig.8

Fig.9.

Fig.10